# EUROPEAN PATENT APPLICATION

(11) **EP 4 741 861 A1**
(43) Date of publication of application: **13.05.2026**
(21) Application number: 25212332.8
(22) Date of filing: 30.10.2025
(51) Int. Cl.: G01R 33/38, G01R 33/3815

(54) **MAGNETIC RESONANCE IMAGING APPARATUS AND METHOD OF CONTROLLING CRYOCOOLER**

(30) Priority: 11.11.2024 JP 2024196767
(71) Applicant: FUJIFILM Corporation, Tokyo 106-8620 (JP)
(72) Inventor: TAKESHI, Yatsuo, Tokyo, 106-8620 (JP)
(74) Representative: Dehns Germany Partnerschaft mbB

(57) **Abstract**

An object is to extend a replacement lifetime of a cryocooler (70) and reduce a replacement frequency of the cryocooler, thereby improving an operating rate of an MRI apparatus (1).

A processor (20) has an imaging mode and a non-imaging mode. In the imaging mode, a displacer is caused to operate continuously at a constant frequency regardless of a pressure in a vessel of a superconducting magnet (101).

## Description

### CROSS-REFERENCE TO RELATED APPLICATIONS

The present application claims priority under 35 U.S.C. § 119 to Japanese Patent Application No. 2024-196767, filed November 11, 2024. Each of the above application(s) is hereby expressly incorporated by reference, in its entirety, into the present application.

### BACKGROUND OF THE INVENTION

### 1. Field of the Invention

The present invention relates to a magnetic resonance imaging (hereinafter, referred to as MRI) apparatus.

### 2. Description of the Related Art

An MRI apparatus that cools a superconducting magnet using liquid helium is known. A superconducting coil is disposed in a liquid helium vessel, and the liquid helium vessel comprises a cold head of a cryocooler that cools vaporized helium to re-liquefy the helium.

JP5960152B discloses a technology of changing a drive frequency of a compressor of a cryocooler to vary the cooling capacity in order to maintain a pressure in a liquid helium vessel constant.

Meanwhile, an MRI apparatus that does not use liquid helium is also known. For example, JP2013-144099A discloses an MRI apparatus that conduction-cools a bobbin of a superconducting coil disposed within a vacuum vessel by cold heads of two or more cryocoolers. An inverter is connected to the compressor of the cryocooler, and the inverter is controlled based on a temperature of a superconducting coil unit. As a result, the capacity of the compressor is changed to control the temperature of the superconducting coil unit to a constant value.

### SUMMARY OF THE INVENTION

The MRI apparatus that uses the superconducting coil requires the cryocooler to cool the superconducting coil. In a case of replacing the cryocooler, the MRI apparatus should be shut down.

An object of the present invention is to extend a replacement lifetime of a cryocooler and reduce a replacement frequency of the cryocooler, thereby improving an operating rate of an MRI apparatus.

An aspect of the present invention provides a magnetic resonance imaging apparatus including: a superconducting magnet that generates a static magnetic field in an imaging space. The superconducting magnet includes a superconducting coil, a vessel that houses the superconducting coil, liquid helium that is disposed in the vessel, a cryocooler that is attached to the vessel, a compressor that supplies compressed refrigerant gas to the cryocooler, and a processor. The compressor includes a mechanism unit, a compressor drive unit that periodically drives the mechanism unit to compress the refrigerant gas, and an inverter for a compressor that adjusts a drive frequency of the compressor drive unit. The cryocooler includes a cylinder into which the refrigerant gas compressed by the compressor is supplied, a displacer that is disposed in the cylinder, a displacer drive unit that periodically drives the displacer in the cylinder, and an inverter for a cryocooler that adjusts a drive frequency of the displacer drive unit. The processor controls the inverter for a compressor and the inverter for a cryocooler to control a pressure in the vessel of the superconducting magnet. The processor has an imaging mode and a non-imaging mode. The processor causes, in the imaging mode, the displacer to operate continuously at a constant frequency regardless of the pressure in the vessel of the superconducting magnet.

According to the aspect of the present invention, in a case of the imaging mode, the operating rate of the MRI apparatus can be improved by extending the replacement lifetime of the cryocooler and reducing the replacement frequency of the cryocooler by causing the displacer to operate continuously at the constant frequency regardless of the pressure in the vessel of the superconducting magnet.

### BRIEF DESCRIPTION OF THE DRAWINGS

FIG. 1 is a block diagram illustrating an overall configuration of an MRI apparatus according to an embodiment of the present invention.
FIG. 2 is a cross-sectional view illustrating the arrangement of a superconducting magnet and the like of the MRI apparatus illustrated in FIG. 1.
FIG. 3 is a diagram illustrating a cross-sectional structure of the superconducting magnet of the MRI apparatus illustrated in FIG. 1.
FIG. 4 is a cross-sectional view illustrating a configuration of a cold head 107 and a compressor 108 of the superconducting magnet illustrated in FIG. 3.
FIG. 5 is a flowchart illustrating control of the cold head 107 and the compressor 108 by a processor of a superconducting magnet according to a first embodiment.
FIG. 6 is a flowchart illustrating control of the cold head 107 and the compressor 108 by a processor of a superconducting magnet according to a modification example of the first embodiment.
FIG. 7 is a flowchart illustrating control of the cold head 107 and the compressor 108 by a processor of a superconducting magnet according to a second embodiment.
FIG. 8A is a graph illustrating an amount of heat input during imaging of a superconducting magnet of a fourth embodiment and an operation frequency of a compressor, and FIG. 8B is a graph illustrating the operation frequency of the compressor and a magnet temperature of the superconducting magnet according to the fourth embodiment.
FIG. 9 is a flowchart illustrating control of the cold head 107 and the compressor 108 by a processor of a superconducting magnet according to the fourth embodiment.
FIG. 10 is a flowchart illustrating control of the cold head 107 and the compressor 108 by a processor of a superconducting magnet according to a modification example of the fourth embodiment.
FIG. 11 is a graph illustrating an amount of heat input during imaging of a superconducting magnet according to a fifth embodiment and a state of an MRI apparatus.
FIG. 12 is a flowchart illustrating control of the cold head 107 and the compressor 108 by a processor of the superconducting magnet according to the fifth embodiment.

### DESCRIPTION OF THE PREFERRED EMBODIMENTS

An MRI apparatus according to an embodiment of the present invention will be described with reference to the drawings. In all the drawings illustrating the embodiments of the invention, components having the same function are denoted by the same reference numerals, and redundant descriptions will not be repeated.

### Overall Configuration of MRI Apparatus of Present Embodiment

First, an overall configuration of the MRI apparatus operated in the present embodiment will be described.

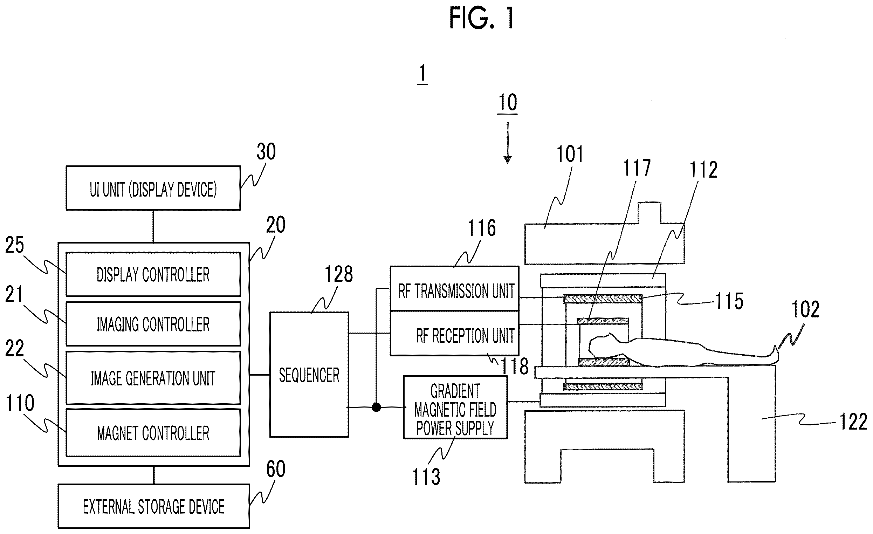

FIG. 1 illustrates the overall configuration of the MRI apparatus according to the present embodiment in a state of being installed in a medical facility.

First, an overall outline of the MRI apparatus to which the present invention is applied will be described. As illustrated in FIG. 1, an MRI apparatus 1 includes an imaging unit 10 that causes nuclear magnetic resonance in atomic nuclei of atoms constituting the tissue of a subject 102 and collects a nuclear magnetic resonance signal generated from the subject 102, a processor 20 that performs processing of the nuclear magnetic resonance signal collected by the imaging unit 10 and controls the imaging unit 10, and a user interface unit (hereinafter, UI unit) 30 that is operated by an operator of the MRI apparatus 1 such as a doctor or a technician (hereinafter, a user) to set imaging conditions, input a command necessary for processing, and display an image obtained by the MRI apparatus 1 or a GUI. In addition, the MRI apparatus 1 may comprise an external storage device 60 that stores the generated image or the like, or an interface (not illustrated) that performs communication with an external device.

The imaging unit 10 includes a superconducting magnet 101 that generates a uniform static magnetic field in an examination space in which the subject 102 is placed, a gradient coil 112 that applies a magnetic field gradient to the static magnetic field, an RF transmit coil 115 that applies a predetermined high-frequency magnetic field to the subject 102, and an RF receive coil 117 that receives the nuclear magnetic resonance signal (hereinafter, also referred to as an echo signal) generated from the subject 102. The gradient coil 112 is connected to a gradient magnetic field power supply 113, the RF transmit coil 115 is connected to an RF transmission unit 116 consisting of an RF transmitter, an RF amplifier, and the like, and the RF receive coil 117 is connected to an RF reception unit 118 comprising a QD detector and an AD converter. In some cases, one RF coil may be used for both the RF transmit coil 115 and the RF receive coil 117, the RF transmit coil 115 is generally housed in a gantry (not illustrated) to surround the examination space together with the superconducting magnet 101 and the gradient coil 112, and the RF receive coil 117 is disposed in the examination space in a state of being attached to the subject 102.

The imaging unit 10 further comprises a sequencer 128 that causes the RF transmission unit 116, the gradient magnetic field power supply 113, and the RF reception unit 118 to operate in accordance with a predetermined pulse sequence, and the imaging is performed in accordance with an imaging sequence set in the sequencer 128. The operation related to the imaging is the same as that of a general MRI apparatus.

The imaging unit 10 further comprises a table device 122 for placing the subject 102.

The processor 20 controls the imaging unit 10 and performs signal processing on the nuclear magnetic resonance signal collected by the imaging unit 10, various operations, and the like.

In order to implement the above-described processing, the processor 20 includes an imaging controller 21 that controls the imaging, a display controller 25 that controls display in the UI unit 30, an image generation unit 22 that performs various operations related to image generation such as image reconstruction, and a magnet controller 110 that controls the superconducting magnet 101.

In the present embodiment, each of the above-described processing of the processor 20 can be executed by any computer. Any computer may execute these types of processing by a processor as hardware, a program as software, or a combination thereof. In such a case, the processor is configured to execute various types of processing in the present embodiment in cooperation with the program, and may function the respective units 21, 22, 25, and 110 or each means in the present embodiment. In addition, the execution order of the processing by the processor is not limited to the above-described order, and may be changed as appropriate. Any computer may be a general-purpose computer, a computer for specific use, a workstation, or another system that can execute each processing.

The processor may be configured by one or more types of hardware, and the type of hardware is not limited. For example, the processor may be configured with hardware such as a central processing unit (CPU), a micro processing unit (MPU), a programmable logic device such as a field-programmable gate array (FPGA), a dedicated circuit for executing specific processing such as an application-specific integrated circuit (ASIC), a graphics processing unit (GPU), or a neural processing unit (NPU). Additionally, the types of hardware may be a combination of different types of hardware. In a case in which the plurality of types of hardware are configured to execute one or a plurality of types of processing of a certain processor, the plurality of types of hardware may be present in devices physically separated from each other or may be present in the same device. Furthermore, in any of the embodiments, the order of each processing performed by the processor is not limited to the above-described order, and may be changed as appropriate. In addition, hardware is implemented in a form of an electric circuit (circuitry) in which circuit elements, such as semiconductor elements, are combined.

Furthermore, the program may be software such as firmware or a microcode. The program may be, for example, a group of program modules, and each function thereof may be implemented by a processor configured to execute each function. The program may be a program code or a plurality of code segments stored in one or more non-transitory computer-readable media (for example, a storage medium and other storages). The program may be stored in the plurality of non-transitory computer-readable media present in devices physically separated from each other. The program code or the code segment may represent any combination of procedures, functions, subprograms, routines, subroutines, modules, software packages, classes, instructions, data structures, or program statements. The program code or the code segment may be connected to another code segment or a hardware circuit by transmitting and receiving information, data, arguments, parameters, or contents in the memory.

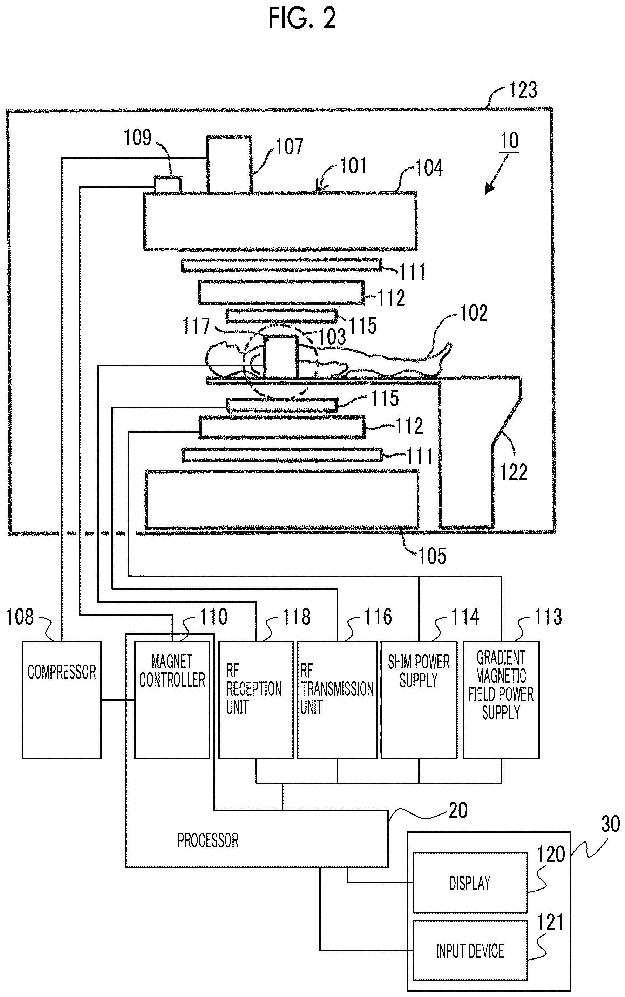

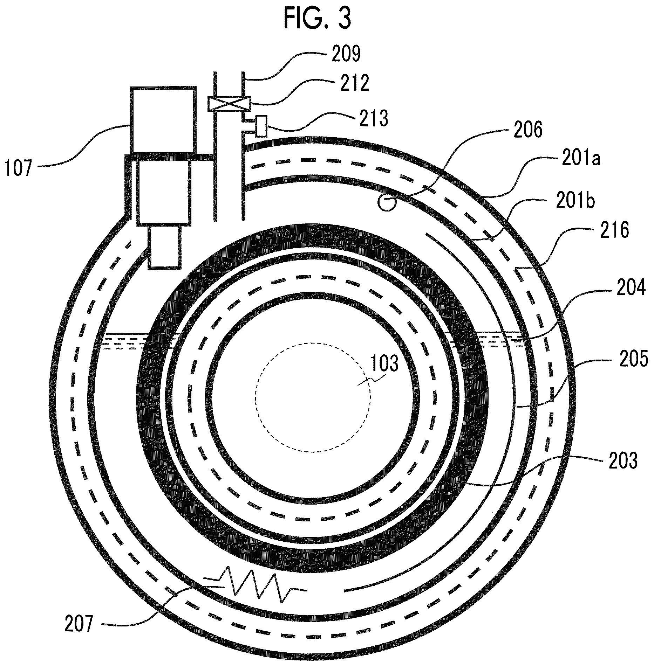

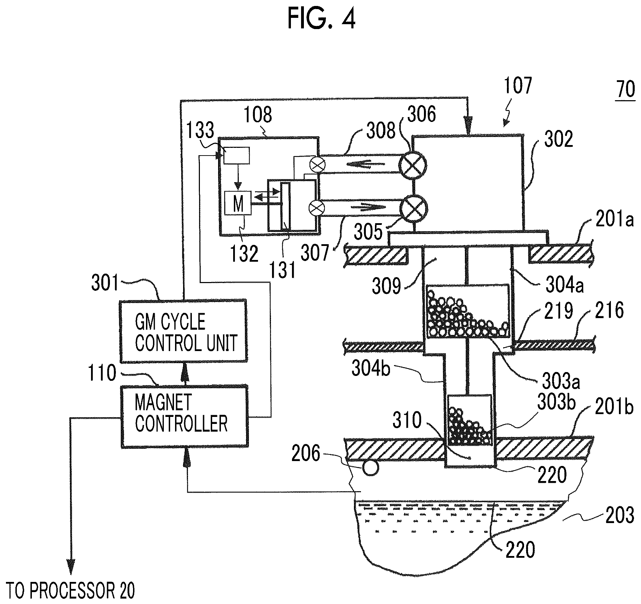

The configuration of the MRI apparatus 1 will be further described with reference to FIGS. 2 to 4. FIG. 2 is a diagram illustrating the arrangement of the superconducting magnet or the like, FIG. 3 is a diagram illustrating a cross-sectional structure of a superconducting magnet 101, and FIG. 4 is a diagram illustrating a structure of a cryocooler 70.

### Superconducting Magnet 101

The MRI apparatus 1 comprises the superconducting magnet 101 as a magnet that generates the static magnetic field. The superconducting magnet 101 may be a magnet that generates the static magnetic field in a vertical direction or a magnet that generates the static magnetic field in a horizontal direction, but the superconducting magnet 101 that generates the static magnetic field in the horizontal direction will be described as an example. As illustrated in FIG. 3, the superconducting magnet 101 that generates the static magnetic field in the horizontal direction generates the static magnetic field in the horizontal direction (body axis direction of the subject 102) by using a superconducting coil 203 in which a coil is wound in a cylindrical shape. The superconducting coil 203 wound in a cylindrical shape is disposed in a cylindrical vacuum vessel 201.

The cylindrical vacuum vessel 201 has a double structure of an outer vessel 201a and an inner vessel 201b. A space between the outer vessel 201a and the inner vessel 201b is evacuated to a predetermined pressure, and a radiative heat shield plate 216 is disposed. The superconducting coil 203 is disposed in the inner vessel 201b.

A space in the inner vessel 201b in the vacuum vessel 201 in which the superconducting coil 203 is disposed is filled with liquid helium 204.

An exhaust pipe 209 penetrates the vacuum vessel 201 to reach the inner vessel 201b. An exhaust valve 212 that is opened in a case in which the pressure in the inner vessel 201b is equal to or higher than a predetermined pressure (for example, 20 kPa) is attached to the exhaust pipe 209. As a result, in a case in which a large amount of helium gas needs to be exhausted, such as when a quench occurs, the exhaust valve 212 is opened, and the helium gas can be exhausted from the exhaust pipe 209. In addition, the exhaust pipe 209 comprises a pressure sensor 213 that measures a pressure of the helium gas generated by vaporization of the liquid helium 204. A heater 207 is disposed in the inner vessel 201b, and the liquid helium 204 is heated and vaporized as necessary to maintain the pressure in the inner vessel 201b at a constant level.

The magnetic-field space 103 in which the subject 102 is disposed is formed in a space near a central axis of the cylindrical vacuum vessel 201.

The vacuum vessel 201 comprises a cold head 107. A distal end of the cold head 107 is inserted into the inner vessel 201b of the vacuum vessel 201. A compressor 108 is connected to the cold head 107, and refrigerant gas compressed by the compressor 108 is supplied to the cold head 107. The cold head 107 and the compressor 108 constitute a cryocooler 70 that cools the superconducting magnet 101.

The cold head 107 generates a cooling effect by adiabatic expansion of the refrigerant gas inside the cold head 107, and the distal end of the cold head 107 is cooled. The distal end of the cold head 107 cools the space in the inner vessel 201b, cools and condenses the helium gas generated by vaporization of the liquid helium in the inner vessel 201b, and returns the helium gas to the liquid helium. As a result, the superconducting magnet 101 is cooled by the liquid helium.

In addition, a part of the cold head 107 is connected to the radiative heat shield plate 216 and the inner vessel 201b of the vacuum vessel 201, and the radiative heat shield plate 216 and the inner vessel 201b are cooled.

In this way, the cryocooler maintains the thermal equilibrium state of the superconducting magnet 101, thereby achieving a closed-cycle superconducting magnet. That is, the cooling capacity is controlled such that the heat input to the vacuum vessel 201 is removed without deficiency or excess.

In addition, a plurality of pressure sensors 213 or temperature sensors 206 for monitoring an operation state of the superconducting magnet 101 are incorporated in the superconducting magnet 101, and a sensor connection terminal 109 is connected to the magnet controller 110.

The magnet controller 110 monitors the operation state of the superconducting magnet 101, and controls the cold head 107 and the compressor 108.

As a result, the superconducting coil 203 is cooled to be equal to or lower than a critical temperature, is in a superconducting state, and can generate a stable static magnetic field of a magnetic field intensity of 1.5 tesla in the magnetic-field space (imaging space) 103 by carrying a predetermined persistent current.

### Shim Plate 111

As illustrated in FIG. 2, a shim plate 111 is attached to a surface of the vacuum vessel 201 facing the magnetic-field space 103. A plurality of screw holes (not illustrated) are opened in the shim plate 111, and small screws made of a magnetic material are embedded at suitable positions. The magnetic field generated by the small screw made of a magnetic material changes a magnetic flux distribution generated by the superconducting magnet 101 to adjust the magnetic field uniformity in the magnetic-field space 103 to a target value (for example, 3 ppm or less).

### Gradient Coil 112

On a surface of the shim plate 111 facing the magnetic-field space 103, the gradient coil 112 that generates the gradient magnetic field is disposed. Each of the gradient coils 112 has a structure in which three types of x-, y-, and z-coils that generate the gradient magnetic field in three-axis directions orthogonal to each other are laminated (not distinguished in FIG. 1). A gradient magnetic field power supply 113 that independently applies a current to the x-coil, the y-coil, and the z-coil is connected.

The gradient coil 112 includes a B₀ coil that compensates for the magnetic field intensity generated by the superconducting magnet 101, a shim coil that generates a magnetic field of higher order modes of x, y, and z, for example, ZX, ZY, XY, Z², x²+y², and the like, in addition to the x-coil, the y-coil, and the z-coil. A current is applied thereto by a shim power supply 114.

### RF Transmit Coil 115

The RF transmit coil 115 is attached to the magnetic-field space 103 side of the gradient coil 112. The RF transmission unit 116 is connected to the RF transmit coil 115, and a high-frequency current is supplied. As a result, a high-frequency magnetic field required for nuclear magnetic resonance of the nuclear spins of an imaging part of the subject 102 is generated.

By combining the above-described stable and high uniformity static magnetic field, the gradient magnetic field, and the high-frequency magnetic field, it is possible to accurately and selectively induce nuclear magnetic resonance (NMR) in the hydrogen nuclei in the imaging part of the subject 102. Then, the gradient magnetic field is applied in a pulsed manner to the precession process of the nuclear spins to add three-dimensional position information.

### RF Receive Coil 117

The RF receive coil 117 is disposed approximately at the center of the magnetic-field space 103, that is, at the imaging part of the subject 102. The RF receive coil 117 detects a slight magnetic field fluctuation caused by the precession of the nuclear spins as an electrical signal (NMR signal) due to an induced current on the RF receive coil 117. The detected NMR signal is passed to the RF reception unit 118 connected to the RF receive coil 117. The RF reception unit 118 performs signal processing such as amplification and detection on the NMR signal, and then converts the NMR signal into a digital signal.

### Processor 20

The image generation unit 22 of the processor 20 generates an MRI image or a spectrum chart from the NMR signal converted into the digital signal. The generated image and the like are stored in the external storage device 60. The display controller 25 displays the MRI image and the like on a display 120 of the UI unit 30.

In addition, the imaging controller 21 of the processor 20 performs control of applying the gradient magnetic field and the high-frequency magnetic field to the subject 102 from the gradient coil 112 and the RF transmit coil 115 at a timing determined in a predetermined imaging sequence, and detecting the generated NMR signal at a predetermined timing in order to implement a predetermined imaging method. The imaging sequence varies depending on the imaging method and the imaging conditions. The imaging controller 21 generates the imaging sequence for achieving the imaging method and the imaging conditions input by the operator via an input device 121 of the UI unit 30 by executing a program stored in advance in a built-in storage device. As a result, a plurality of types of imaging methods can be achieved under various imaging conditions. The input device 121 is, for example, a keyboard or a mouse.

The operation states of the magnet controller 110, the gradient magnetic field power supply 113, the shim power supply 114, the RF transmission unit 116, the RF reception unit 118, and the like are recorded in the storage device built in the processor 20. In addition, the processor 20 can also output the information on the operation states to the outside via a communication control device (not illustrated). As a result, it is possible to remotely monitor the MRI apparatus.

### Table Device 122

The MRI apparatus comprises a table device 122 that transports the imaging part of the subject 102 to the center of the magnetic-field space 103.

The superconducting magnet 101 and the table device 122 are installed in an examination room 123 that is electromagnetically shielded. As a result, electromagnetic waves generated by the external device are prevented from being mixed into the RF receive coil 117 as noise, and the quality of the diagnostic image is prevented from being deteriorated.

### Details of Structure of Vacuum Vessel 201 of Superconducting Magnet

A detailed structure of the vacuum vessel 201 of the superconducting magnet 101 will be further described with reference to FIG. 3.

A load support (not illustrated) is attached to the outer vessel 201a of the vacuum vessel 201 of the superconducting magnet 101, the radiative heat shield plate 216, and the inner vessel 201b to fix the relative positions thereof. The load support is made of stainless steel and resin in order to minimize conduction heat.

The outer vessel 201a of the vacuum vessel 201 is made of, for example, stainless steel having a thickness of 10 millimeters. The inner vessel 201b is made of, for example, stainless steel having a thickness of 15 millimeters, and has rigidity that can withstand the electromagnetic force applied to the superconducting coil 203 and a pressure difference between the inside and the outside.

The superconducting coil 203 in the inner vessel 201b is composed of a plurality of coils. The superconducting coil 203 is fixed to the inner vessel 201b.

The temperature sensor 206 for measuring the temperature is installed in the inner vessel 201b. An output signal line of the temperature sensor 206 is drawn from the sensor connection terminal 109 to the outside of the superconducting magnet 101.

The radiative heat shield plate 216 is made of aluminum having a thickness of 5 millimeters. A surface thereof is mirror polished to reduce radiative heat. In addition, a superinsulator (not illustrated) is laid between the vacuum vessel 201 and the radiative heat shield plate 216. The superinsulator 217 is composed of a multilayer of polyethylene sheets on which aluminum thin films are vapor-deposited, and radiative heat is reduced.

The inner vessel 201b is filled with a predetermined amount (approximately 30% to 90% of the vessel volume) of the liquid helium 204, and the superconducting coil 203 is immersed in the liquid helium 204. As a result, the superconducting coil 203 can be cooled to 4.2 K (-268.8°C), which is a boiling point temperature of the liquid helium 204, and can be maintained in the superconducting state.

The pressure sensor 213 detects the pressure in a space in the inner vessel 201b, which is not filled with the liquid helium 204. In addition, a liquid level sensor 205 that measures a liquid level of the liquid helium 204 is disposed in the inner vessel 201b. An output signal line of the liquid level sensor 205 is drawn from the sensor connection terminal 109 to the outside of the superconducting magnet 101.

### Details of Vacuum Vessel 201 of Superconducting Magnet

The cold head 107 is disposed in the vacuum vessel 201. As illustrated in FIG. 4, the cold head 107 includes two cooling stages, and a first cooling stage 219 of the first stage is 43 K (-230°C), and a second cooling stage 220 of the second stage is 4 K (-269°C).

The first cooling stage 219 of the cold head 107 is thermally in contact with the radiative heat shield plate 216, and cools the radiative heat shield plate 216. A distal end of the second cooling stage 220 of the cold head 107 is inserted into the inner vessel 201b.

The distal end of the second cooling stage 220 directly cools the helium gas in the inner vessel 201b to condense and liquefy the helium gas to the boiling point of 4.2 K. The liquid helium cools the superconducting coil 203.

### Details of Cryocooler 70

Next, a detailed structure of the cryocooler 70 will be described with reference to FIG. 4.

The cold head 107 comprises cylinders 304a and 304b having a two-stage structure including the first cooling stage 219 and the second cooling stage 220, displacers 303a and 303b having a two-stage structure, and a displacer drive unit 302 that causes the displacers 303a and 303b to reciprocate in the cylinders 304a and 304b. In the displacer 303, a first stage is filled with lead balls, and a second stage is filled with copper holmium balls as a cooling storage material, and the displacer 303 has a structure in which the cooling storage material is thermally exchanged in a process in which the refrigerant gas passes through the displacer 303.

The displacer drive unit 302 comprises an intake valve 305 that takes in the refrigerant gas compressed by the compressor 108, and an exhaust valve 306 that exhausts the refrigerant gas. These valves are opened and closed in synchronization with the reciprocation of the displacer 303. The intake valve 305 and the exhaust valve 306 are connected to the compressor 108 via pressure gas hoses 307 and 308, respectively.

As illustrated in FIG. 4, the cryocooler 70 comprises a GM cycle control unit 301 (not illustrated in FIG. 2) between the cold head 107 and the magnet controller 110. The GM cycle control unit 301 causes a motor of the displacer drive unit 302 of the cold head 107 to operate at a frequency indicated by the magnet controller 110. Specifically, the GM cycle control unit 301 controls a frequency of drive power output to the displacer drive unit 302 of the cold head 107.

The compressor 108 comprises a mechanism unit 131 such as a cylinder and a piston, a compressor drive unit 132 that periodically drives the piston of the mechanism unit 131 to compress the refrigerant gas in the cylinder, and an inverter for a compressor 133 that adjusts a drive frequency of the compressor drive unit 132.

The cold head 107 operates in steps (1) to (3) described below in order to generate the cooling effect.
(1) In a case in which the displacers 303a and 303b are moved toward a distal end (downward) of the cold head 107, an upper space 309 in the cylinder 304a is filled with the compressed refrigerant gas suctioned from the compressor 108.
(2) Next, in a case in which the displacers 303a and 303b are moved upward, the compressed refrigerant gas passes through a regenerator material in the displacers 303a and 303b and moves to a lower space 310.
(3) The exhaust valve 306 is opened in synchronization with the displacers 303a and 303b reaching the uppermost position. The refrigerant gas in the cylinders 304a and 304b is adiabatically expanded due to the pressure drop, and the temperature drops. Then, the refrigerant gas returns to the compressor 108 via the pressure gas hose 308 from the exhaust valve 306.

By repeating the cycles of (1) to (3), the refrigerant gas continuously absorbs heat from the lower space 310 of the cylinder 304. This thermal cycle is called a Gifford-McMahon cycle (GM cycle), and a cooling apparatus using the GM cycle is called a GM-type cryocooler.

### First Embodiment

In the first embodiment, the processor 20 has an imaging mode and a non-imaging mode, and causes, in the imaging mode, the displacers 303a and 303b to operate continuously at a constant frequency regardless of the pressure in the inner vessel 201b of the superconducting magnet 101. It is preferable that the frequency at which the displacers 303a and 303b operate be set lower than the drive frequency of the compressor drive unit 132.

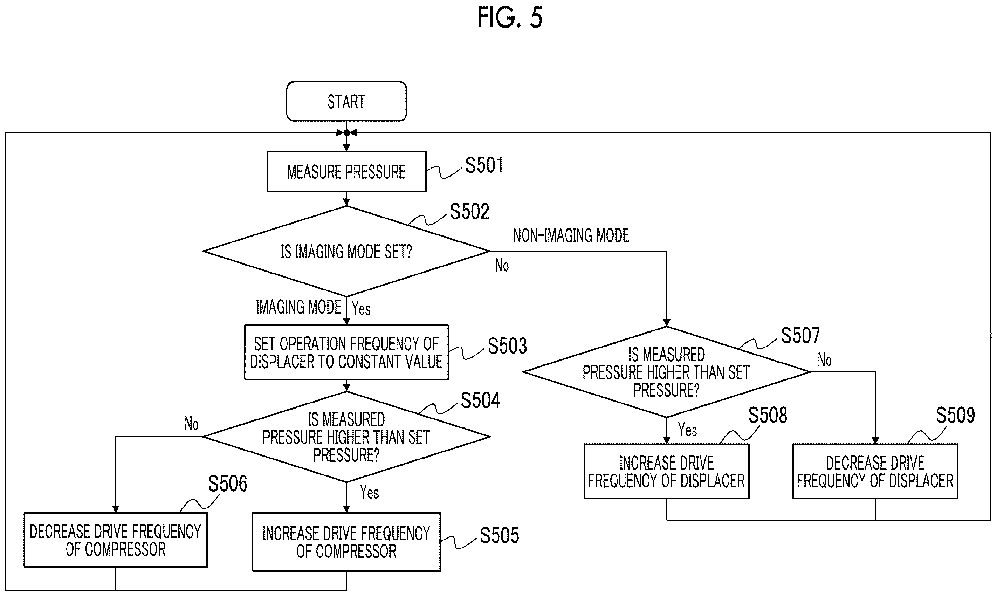

The operation will be specifically described with reference to the flow illustrated in FIG. 5.

### Step S501

First, the magnet controller 110 proceeds to step S502, and acquires the pressure from the pressure sensor 213 in the inner vessel 201b.

### Step S502

The magnet controller 110 determines whether to execute the imaging mode or the non-imaging mode.

For example, in a case in which the imaging controller 21 of the MRI apparatus 1 is executing the imaging protocol (the imaging sequence for achieving a desired imaging method) or an individual sequence under that protocol, the magnet controller 110 executes the imaging mode.

For example, in a case in which the operator sets a predetermined specific mode (for example, in a case in which the operator presses a start button on the input device 121), the magnet controller 110 may execute the imaging mode for a predetermined period (from when the start button is pressed to when a series of imaging operations ends).

For example, in a case in which the table device 122 is in a predetermined operation or at a predetermined position (for example, in a case in which the operator presses the start button and starts to transport the top plate of the table device 122, on which the subject 102 is placed, toward the magnetic-field space 103 in the gantry, and the top plate returns to the original position until the series of imaging operations ends), the magnet controller 110 may execute the imaging mode.

For example, in a case in which the magnet controller 110 is set to execute the imaging mode by the operator or the service technician operating the input device 121 of the UI unit 30 or performing a remote operation via a communication control device (not illustrated in FIGS. 1 and 2) provided in the MRI apparatus 1, the imaging mode is executed regardless of whether the imaging is in progress.

On the other hand, in a case in which the magnet controller 110 does not execute the imaging mode, the magnet controller 110 executes the non-imaging mode. For example, in a case in which the imaging controller 21 does not execute the imaging protocol or in a case in which the operator sets a predetermined specific mode (for example, in a case in which the operator sets a standby mode, a sleep mode, or a low power consumption mode in the input device 121), the magnet controller 110 executes the non-imaging mode.

For example, in a case in which the table device 122 is at a predetermined position (for example, in a case in which a top plate of the table device 122 is at an initial position (predetermined position before the subject 102 is placed)), the magnet controller 110 may execute the non-imaging mode.

In a case in which the imaging mode is executed, the processing proceeds to step S503. In a case in which the non-imaging mode is executed, the processing proceeds to step S507.

### Step S503

The magnet controller 110 instructs the GM cycle control unit 301 to set the frequency at which the displacers 303a and 303b of the cold head 107 operate, to the constant drive frequency lower than the predetermined upper limit frequency.

As a result, the displacers 303a and 303b of the cold head 107 operate at the predetermined constant drive frequency regardless of the pressure in the inner vessel 201b of the superconducting magnet 101.

The magnet controller 110 proceeds to step S504.

### Steps S504 to S506

Next, in a case in which the pressure acquired from the pressure sensor 213 is higher than a set pressure (step S504), the magnet controller 110 proceeds to step S505 and instructs the inverter for a compressor 133 of the compressor 108 to increase the drive frequency of the compressor drive unit 132. As a result, the drive frequency of the compressor drive unit 132 is increased, and thus the pressure of the refrigerant gas sent from the compressor 108 to the cold head 107 is increased.

On the other hand, in a case in which the pressure acquired from the pressure sensor 213 is equal to or lower than the set pressure, the magnet controller 110 proceeds to step S506 and instructs the inverter for a compressor 133 of the compressor 108 to decrease the drive frequency of the compressor drive unit 132. As a result, the drive frequency of the compressor drive unit 132 is decreased, and thus the pressure of the refrigerant gas sent from the compressor 108 to the cold head 107 is decreased.

As described above, by increasing or decreasing the drive frequency of the compressor drive unit 132 via the magnet controller 110 in accordance with the pressure in the inner vessel 201b of the superconducting magnet 101, the pressure of the refrigerant gas sent to the cold head 107 changes, so that, even in a case in which the drive frequencies of the displacers 303a and 303b of the cold head 107 are constant, the cooling capacity of the cold head 107 can be adjusted to maintain the pressure in the inner vessel 201b of the superconducting magnet 101 constant.

The set pressure in step S504 may be a specific pressure or may be in a pressure range. In a case in which the pressure range is used as the set pressure, in a case in which the pressure acquired from the pressure sensor 213 is higher than the upper limit value of the set pressure range, the magnet controller 110 proceeds to step S505, and in a case in which the pressure is equal to or lower than the lower limit value of the set pressure range, the magnet controller 110 proceeds to step S506. In a case in which the pressure acquired from the pressure sensor 213 is higher than the lower limit value and equal to or lower than the upper limit value, the magnet controller 110 does not control the compressor 108 and returns to step S501.

### Steps S507 to S509

On the other hand, in step S507, the magnet controller 110 executes the non-imaging mode. Specifically, in a case in which the pressure acquired from the pressure sensor 213 is higher than the set pressure, the processing proceeds to step S508. In step S508, the magnet controller 110 instructs the GM cycle control unit 301 to increase the frequency at which the displacer drive unit 302 of the cold head 107 operates. As a result, the drive frequencies of the displacers 303a and 303b are increased, and thus the cooling capacity of the cold head 107 can be increased.

On the other hand, in step S507, in a case in which the pressure acquired from the pressure sensor 213 is lower than the set pressure, the magnet controller 110 proceeds to step S509. In step S509, the magnet controller 110 instructs the GM cycle control unit 301 to decrease the frequency at which the displacer drive unit 302 of the cold head 107 operates. As a result, the drive frequencies of the displacers 303a and 303b are decreased, and thus the cooling capacity of the cold head 107 can be decreased.

As a result, in steps S507 to S509, the magnet controller 110 can adjust the cooling capacity of the cold head 107 by increasing or decreasing the drive frequencies of the displacers 303a and 303b, and can maintain the pressure in the inner vessel 201b of the superconducting magnet 101 at a constant level.

The set pressure in step S507 may be a specific pressure or may be in a pressure range, like the set pressure in step S504.

As described above, in the present embodiment, in the imaging mode, in step S503, the frequencies at which the displacers 303a and 303b of the cold head 107 operate are set to a constant value smaller than a predetermined upper limit value. Therefore, the reciprocation frequencies of the displacers 303a and 303b are reduced as compared with a case in which the drive frequencies of the displacers 303a and 303b are increased or decreased in accordance with the pressure as in steps S507 to S509, and thus the wear and failure of the displacers 303a and 303b can be reduced, and the lifetime of the cold head 107 can be extended.

The effects of the present embodiment will be described in more detail.

In a cryocooler of an MRI apparatus in the related art, a synchronous motor that rotates at a constant rotational speed (synchronous speed) as long as the power supply frequency is constant is used as the motor of the displacer drive unit 302 of the cold head 107, and the displacers 303a and 303b are driven at the frequency corresponding to the frequency of a commercial alternating-current power supply. For example, the synchronous motor that causes the displacers 303a and 303b to operate at 1 Hz for a power supply frequency of 50 Hz is used as the displacer drive unit 302. In the MRI apparatus, in a region in which the frequency of the commercial alternating-current power supply is 60 Hz, the displacers 303a and 303b are driven at 1.2 Hz.

On the other hand, in the present embodiment, the GM cycle control unit 301 controls the displacers 303a and 303b to operate at 0.8 Hz, which is lower than 1 Hz or 1.2 Hz, in step S503.

Since the frequencies of the displacers 303a and 303b are reduced, the frequency of the reciprocating motion is reduced, and thus the lifetime of the cold head 107 can be extended by the same amount.

Therefore, in step S503, the upper limit of the frequency at which the magnet controller 110 instructs the GM cycle control unit 301 to operate the displacers 303a and 303b is set to be lower than the operation frequency of the displacer of the cryocooler of the MRI apparatus in the related art (1 Hz or 1.2 Hz in the above-described example).

For example, the upper limit of the operation frequencies of the displacers 303a and 303b is preferably 1 Hz or less, and particularly preferably 0.8 Hz or less.

The configuration of the displacer drive unit 302 of the cold head 107 according to the present embodiment may be any configuration as long as the operation frequencies of the displacers 303a and 303b can be set to a constant value lower than the predetermined upper limit. For example, as in the cryocooler of the related art, the synchronous motor may be used, or the operation frequencies of the displacers 303a and 303b may be set to a predetermined constant value by the output frequency of the GM cycle control unit 301.

In the present embodiment, the magnet controller 110 reduces the operation frequencies of the displacers 303a and 303b to a constant value (step S503), but the magnet controller 110 controls the drive frequency of the compressor 108 to be variable (steps S505 and S506), so that the cooling performance of the entire cryocooler 70 is not deteriorated.

In addition, it is preferable that the drive frequency of the displacer drive unit 302 of the cold head 107 and the operation frequencies of the displacers 303a and 303b be set to avoid the natural frequency of the superconducting magnet 101. This is because, in a case in which the displacer drive unit 302 or the displacers 303a and 303b operate near the natural frequency of the superconducting magnet 101, the vibration propagates into the superconducting magnet 101, which may cause an unintended vibration of the structure and may cause deterioration in image quality of the MRI image. For example, in a case in which the synchronous motor that causes the displacers 303a and 303b to operate at a frequency of 1/50 of the input power supply frequency is used as the displacer drive unit 302, it is preferable that the power supply frequency input to the displacer drive unit 302 be set to avoid 50 times the natural frequency of the superconducting magnet 101.

As the control method of steps S504 to S506 and S507 to S509, the example has been described in which the drive frequency of the compressor 108 or the operation frequencies of the displacers 303a and 303b are increased or decreased depending on whether the measured pressure is higher or lower than the set pressure, but various known control methods are available, and thus a desired method can be used. For example, PID control, which is one type of feedback control, can be used.

As described above, in the MRI apparatus 1 according to the present embodiment, in the cold head lifetime extension mode, the displacers 303a and 303b are driven at the constant frequency lower than the predetermined upper limit frequency regardless of the pressure in the inner vessel 201b of the superconducting magnet 101, so that the number of reciprocating motions can be reduced as compared with the displacers in the related art, and the replacement lifetime of the cold head 107 can be extended. Further, the cooling capacity of the entire cryocooler 70 can be maintained by controlling the drive frequency of the displacer drive unit 302.

In addition, in the imaging mode of the MRI apparatus 1 according to the present embodiment, the displacers 303a and 303b are driven at the constant frequency lower than the predetermined upper limit frequency regardless of the pressure in the inner vessel 201b of the superconducting magnet 101, so that the operation frequencies of the displacers 303a and 303b are not changed in the middle of the imaging sequence even in a case in which the imaging sequence is executed.

In a case in which the operation of the displacers 303a and 303b is stopped or started or the operation frequency is changed in the middle of the imaging sequence, the vibration state of the superconducting magnet 101 changes, which may cause deterioration in the captured image. However, in the present embodiment, since the displacers 303a and 303b always operate at a constant frequency in the imaging mode, which has the advantage of preventing deterioration in the captured image.

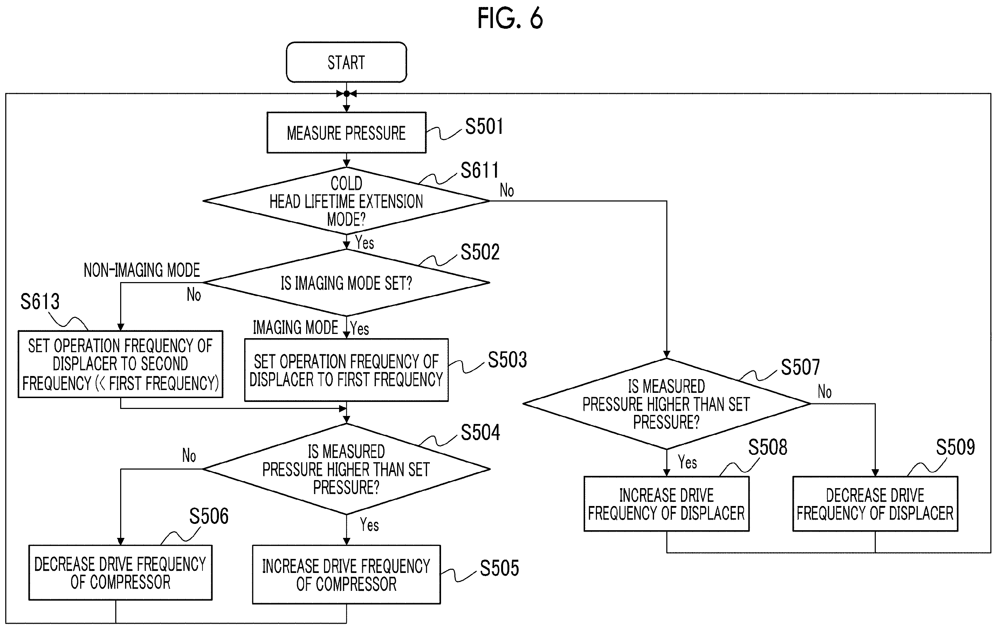

As illustrated in FIG. 6, the user or the operator can also set the cold head lifetime extension mode by using the input device 121 or through the remote operation. In this case, the magnet controller 110 acquires the pressure from the pressure sensor 213 in the inner vessel 201b in step S501, and proceeds to step S611. In step S611 illustrated in FIG. 6, the magnet controller 110 determines whether or not the cold head lifetime extension mode is set. In a case in which the cold head lifetime extension mode is not set, the magnet controller 110 executes steps S507 to S509. On the other hand, in step S611, in a case in which the cold head lifetime extension mode is set, the magnet controller 110 proceeds to step S502 to determine whether or not to execute the imaging mode or the non-imaging mode.

In step S502, in a case in which the magnet controller 110 determines to execute the imaging mode, the magnet controller 110 proceeds to step S503 to cause the displacers 303a and 303b to operate continuously at a constant first frequency regardless of the temperature of the superconducting coil.

On the other hand, in step S502, in a case in which the magnet controller 110 determines to execute the non-imaging mode, the magnet controller 110 proceeds to step S613 to cause the displacers 303a and 303b to operate continuously at a constant second frequency.

The second frequency is set to be smaller than the first frequency of the imaging mode in consideration of a small amount of heat input to the superconducting magnet 101 while the imaging is not being performed. The second frequency may be set by the magnet controller 110 in accordance with the temperature acquired in step S501.

Accordingly, in a case in which the cold head lifetime extension mode is set, in the non-imaging mode, the number of operations is further reduced as compared with the imaging mode, so that the lifetime of the cold head 107 can be extended.

### Second Embodiment

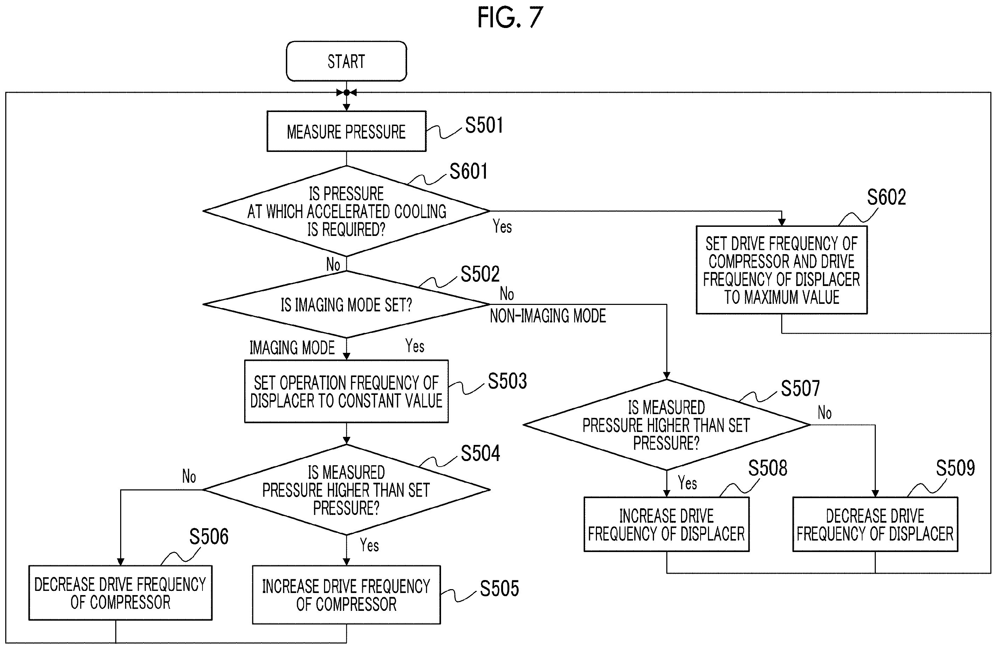

Next, a second embodiment will be described with reference to the flow illustrated in FIG. 7.

The MRI apparatus 1 according to the second embodiment has the same configuration as the first embodiment, but as illustrated in FIG. 7, the magnet controller 110 determines whether or not the accelerated cooling is required based on the pressure acquired from the pressure sensor 213 (step S501), and proceeds to step S602 in a case in which the accelerated cooling is required (step S601).

In step S602, the magnet controller 110 controls the inverter for a compressor 133 so that the drive frequency of the mechanism unit 131 of the compressor 108 is set to the maximum value that can be set. At the same time, the magnet controller 110 instructs the GM cycle control unit 301 to set the operation frequencies of the displacers 303a and 303b of the cold head 107 to the maximum value that can be set.

As a result, the superconducting coil 203 is cooled as quickly as possible.

In a case in which the magnet controller 110 determines in step S601 illustrated in FIG. 7 that the accelerated cooling is not required, step S502 and subsequent steps are executed in the same manner as in the first embodiment.

A case in which the magnet controller 110 determines in step S601 that the accelerated cooling is required is as follows.

Examples of such states include immediately after transporting the MRI apparatus 1, a case in which a quench occurs in the superconducting coil 203, and a case in which the cryocooler 70 is replaced. Under these states, because a steady static magnetic field cannot be generated, the MRI apparatus cannot perform the imaging, and it is required to complete cooling of the superconducting coil 203 as quickly as possible.

Therefore, in the second embodiment, in step S602, the magnet controller 110 performs control so that the drive frequency of the mechanism unit 131 of the compressor 108 is set to the maximum value that can be set, and the operation frequencies of the displacers 303a and 303b of the cold head 107 are also set to the maximum value that can be set. In addition, the liquid helium is added to the inner vessel 201b as necessary.

As a result, the power consumption may be increased, and the vibration of the static magnetic field may also be increased, but the cooling completion of the superconducting coil 203 is prioritized.

Since the state in which the unsteady cooling capacity is required may occur at night, it is desirable that the magnet controller 110 performs automatic determination. Therefore, in step S601, in a case in which it is determined that the pressure detected by the pressure sensor 213 exceeds the pressure that is not possible in the steady state, the processing proceeds to step S602, and the accelerated cooling is executed.

The critical point of the superconducting state is determined by three factors of the temperature, the applied magnetic field, and the current value, and the superconducting state cannot be maintained in a case in which the critical point is exceeded. The applied magnetic field and the current value are known at the design stage, so that the critical temperature is determined in advance based on these values.

In step S501, the pressure can also be acquired from a pressure sensor of the superconducting magnet 101 other than the pressure sensor 213. Further, the determination in step S601 may be made using a detection result other than the pressure in the inner vessel 201b of the superconducting magnet 101. For example, a magnetic field sensor that detects the magnetic field of the superconducting magnet 101 may be disposed, and in a case in which the magnetic field is not detected in step S601, the processing may proceed to step S602, and the cooling capacity may be maximized.

The configuration and the operation of the MRI apparatus 1 according to the second embodiment other than those described above are the same as those of the first embodiment, so that the description thereof will not be repeated.

### Third Embodiment

Next, a third embodiment will be described.

The MRI apparatus 1 according to the third embodiment has the same configuration as the first embodiment, but the processor 20 matches the frequency determined from the parameter of the imaging sequence executed by the imaging unit 10 for the imaging with the constant frequency at which the displacers 303a and 303b are driven. Specifically, the operation frequencies of the displacers 303a and 303b and the drive frequency of the displacer drive unit 302 are set to n times (n is an integer) of the reciprocal (1/(TR)) of the repetition time (TR) of the imaging sequence.

Since the cold head 107 of the cryocooler 70 is inserted into the superconducting magnet 101, the vibration caused by the operation of the displacers 303a and 303b and the operation of the displacer drive unit 302 causes a minute vibration in the superconducting magnet 101. Therefore, in the first embodiment, it is desirable that the operation frequencies of the displacers 303a and 303b and the operation frequencies of the displacer drive unit 302 be set not to match the natural frequency of the superconducting magnet 101.

In the third embodiment, the operation frequencies of the displacers 303a and 303b of the cold head 107 and the operation frequencies of the displacer drive unit 302 are set to n times (n is an integer) of the reciprocal (1/(TR)) of the repetition time (TR) of the imaging sequence. As a result, the fluctuation in the magnetic field caused by the vibration of the superconducting magnet 101 can be synchronized with the imaging sequence, so that the influence of the vibration of the cold head 107 on the imaging can be minimized.

The fluctuation in the magnetic field that is not synchronized with the TR of the imaging sequence cannot be corrected even by post-processing the NMR signal acquired by the imaging, but the influence thereof can be reduced in a case in which the fluctuation in the magnetic field is synchronized with the imaging sequence.

A specific vibration frequency will be described. The displacer drive unit of the cold head of the MRI apparatus in the related art uses the synchronous motor, receives power of 50 Hz or 60 Hz supplied from the commercial alternating-current power supply, and causes the displacer to operate at 1 Hz or 1.2 Hz. Therefore, the vibration occurs at 1 Hz or 1.2 Hz, and the fluctuation in the magnetic field occurs at 1 Hz or 1.2 Hz in the superconducting magnet 101.

In the third embodiment, the drive frequency of the displacer drive unit 302 of the cold head 107 is changed in a range of, for example, 40 Hz to 70 Hz in accordance with the imaging sequence. In a case in which the same synchronous motor as that in the related art is used as the displacer drive unit 302, in a case in which the supplied alternating-current power supply is the commercial alternating-current power supply of 50 Hz, the operation frequencies of the displacers 303a and 303b are 1 Hz, and thus, in a case in which the drive frequency of the displacer drive unit 302 is set in a range of, for example, 40 Hz to 70 Hz, the operation frequency of the displacers 303a and 303b is 0.8 Hz to 1.4 Hz. This corresponds to one cycle of 1250 ms to 714 ms.

For example, in a case of the imaging sequence with the repetition time (TR) of 800 ms, the frequency is 1/0.8 = 1.25 Hz, and thus, in a case in which 1.25 × 50 = 62.5 Hz is selected as the drive frequency of the displacer drive unit 302, the repetition time (TR) of the imaging sequence and the operation frequencies of the displacers 303a and 303b of the cold head 107 can be synchronized.

In this way, according to the third embodiment, the fluctuation in the magnetic field caused by the vibration of the superconducting magnet 101 can be synchronized with the imaging sequence, so that the influence of the vibration of the cold head 107 on the imaging can be reduced.

### Fourth Embodiment

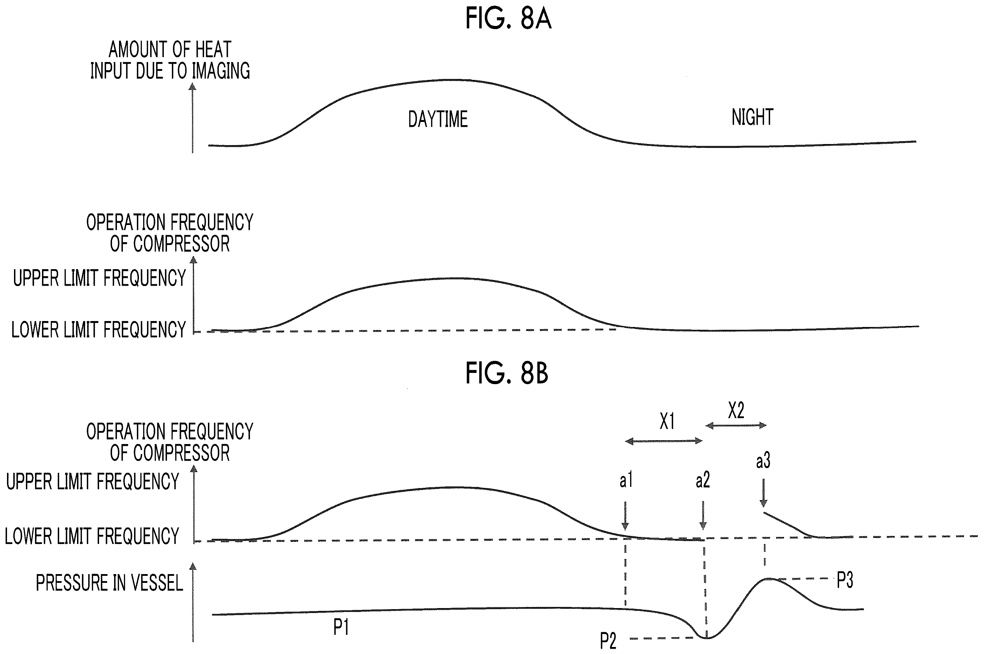

Next, a fourth embodiment will be described with reference to FIGS. 8 to 10.

The MRI apparatus 1 according to the fourth embodiment has the same configuration and operation as those of the first embodiment, but the energy consumption is reduced as compared with the first embodiment.

In a case in which the user sets the imaging mode and the imaging mode is maintained after the imaging ends, the pressure in the inner vessel 201b of the superconducting magnet 101 may be decreased at night or the like, and the drive frequency of the compressor drive unit 132 of the compressor 108 may reach a predetermined lower limit value. In such a case, in the fourth embodiment, the operations of the compressor drive unit 132 of the compressor 108 and the displacers 303a and 303b of the cold head 107 are stopped. Hereinafter, the description thereof will be made in detail.

In the flow illustrated in FIG. 5 of the first embodiment, in a case in which the imaging mode is set, steps S503 to S506 are executed. As a result, the displacers 303a and 303b operate at the constant frequency, and the pressure of the cold head 107 is controlled to be constant by increasing or decreasing the drive frequency of the compressor drive unit 132 of the compressor 108 in accordance with the pressure in the inner vessel 201b of the superconducting magnet 101.

By performing such control, in a case in which the imaging sequence is executed in the MRI apparatus 1 during the daytime, and the heat is input to the superconducting magnet 101, the pressure can be controlled to be constant by steps S503 to S506 (FIG. 8A).

However, in a case in which the amount of heat input is small at night or the like, the drive frequency of the compressor drive unit 132 of the compressor 108 may reach the lower limit frequency as illustrated in FIG. 8A. In a case in which the state in which the drive frequency of the compressor drive unit 132 reaches the lower limit frequency is continued, the pressure in the inner vessel 201b of the superconducting magnet 101 is excessively decreased as compared with a predetermined pressure as illustrated in FIG. 8B.

Therefore, in the fourth embodiment, control of temporarily stopping the operations of the compressor drive unit 132 of the compressor 108 and the displacers 303a and 303b of the cold head 107 is performed.

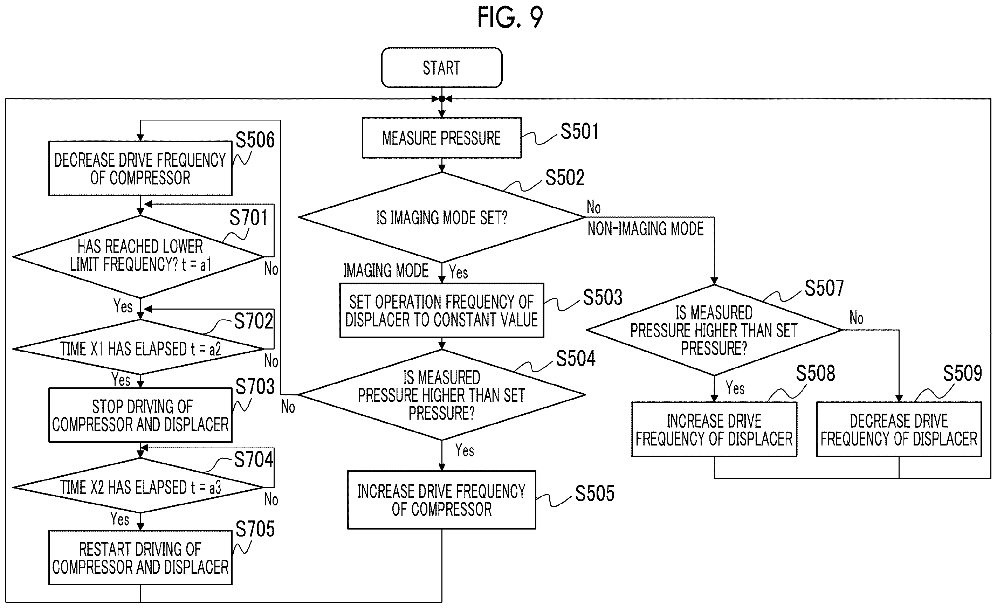

The control of the magnet controller 110 according to the fourth embodiment will be described with reference to the flow illustrated in FIG. 9.

### Steps S501 to S506

In the flow illustrated in FIG. 9, steps S501 to S506 are the same operations as those in the first embodiment.

### Step S701

In step S504, the pressure in the inner vessel 201b of the superconducting magnet 101 is equal to or lower than the set pressure P1, and the magnet controller 110 performs control of decreasing the drive frequency of the compressor drive unit 132 in step S506. As a result, in a case in which the drive frequency of the compressor drive unit 132 reaches the lower limit value, the magnet controller 110 sets this time to a1 (step S701).

### Steps S702 and S703

Even in a case in which the drive frequency of the compressor drive unit 132 reaches the lower limit value, the cold head 107 has the cooling capacity equal to or greater than the amount of heat input, and thus the pressure in the inner vessel 201b of the superconducting magnet 101 starts to decrease as illustrated in FIG. 8B. In a case in which predetermined X1 hours have elapsed from the time a1 and the time has reached a time a2 (step S702), the magnet controller 110 proceeds to step S703 and stops the operations of the compressor drive unit 132 of the compressor 108 and the displacers 303a and 303b of the cold head 107. In this case, the pressure in the inner vessel 201b of the superconducting magnet 101 is decreased to the pressure P2.

### Steps S704 and 705

Since the operation of the compressor 108 and the cold head 107 is stopped by the magnet controller 110, no further cooling is performed. As a result, the pressure increases as illustrated in FIG. 8B.

Therefore, in a case in which X2 hours have elapsed from the time when the compressor 108 and the cold head 107 are stopped in step S703 and the time has reached a time a3, the magnet controller 110 restarts the compressor 108 and the cold head 107 and returns to step S501.

In this case, since the pressure is increased to the pressure P3, the pressure in the inner vessel 201b of the superconducting magnet 101 is controlled to approach the set pressure P1 by the control of the drive frequency of the compressor drive unit 132 of the compressor 108 in steps S501 to S505.

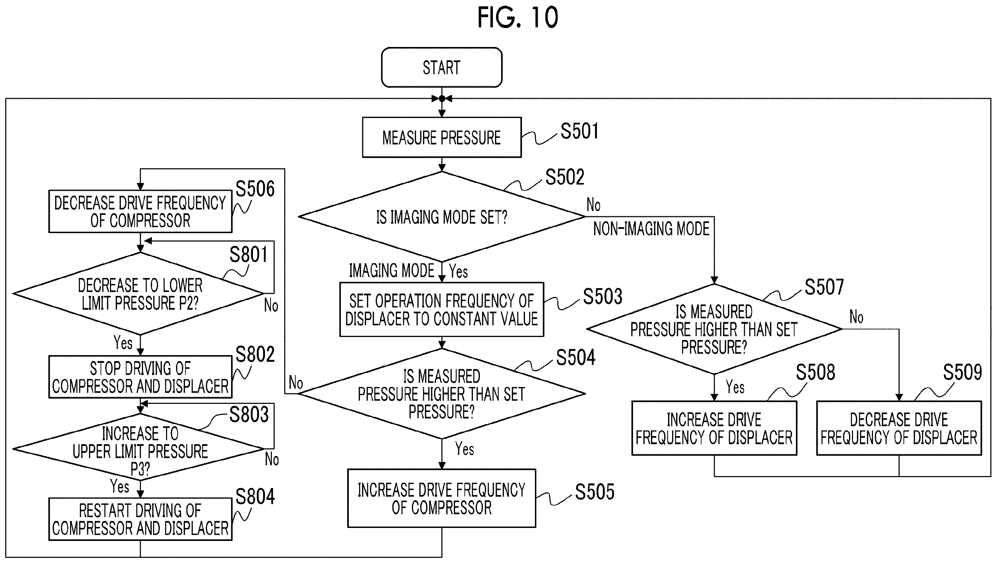

The control can be performed based on the pressure in the inner vessel 201b of the superconducting magnet 101 as in the flow illustrated in FIG. 10 instead of performing the control based on the time as in the flow illustrated in FIG. 9.

### Steps S501 to S506

In the flow illustrated in FIG. 10, the steps S501 to S506 are the same operations as those in the first embodiment.

### Steps S801 and S802

In step S506, in a case in which the drive frequency of the compressor drive unit 132 reaches the lower limit value, the magnet controller 110 continuously monitors the pressure in the inner vessel 201b of the superconducting magnet 101 and stops the operations of the compressor drive unit 132 of the compressor 108 and the displacers 303a and 303b of the cold head 107 when the pressure reaches the lower limit pressure P2.

### Steps S803 and S804

The magnet controller 110 continuously monitors the pressure in the inner vessel 201b of the superconducting magnet 101, restarts the compressor drive unit 132 of the compressor 108 and the displacers 303a and 303b of the cold head 107 when the pressure is increased to the upper limit pressure P3, and returns to step S501.

In the flow illustrated in FIG. 9, it is necessary to set appropriate times X1 and X2 in advance such that the restart of step S705 does not frequently occur. Similarly, in the flow illustrated in FIG. 10, it is necessary to set appropriate P2 and P3 in advance such that the restart of step S804 does not frequently occur and P3 does not excessively exceed P1.

As described above, in the fourth embodiment, in a case in which the drive frequency of the compressor drive unit 132 of the compressor 108 reaches the predetermined lower limit value, the operations of the compressor 108 and the cold head 107 are stopped, so that the energy consumption can be reduced.

### Fifth Embodiment

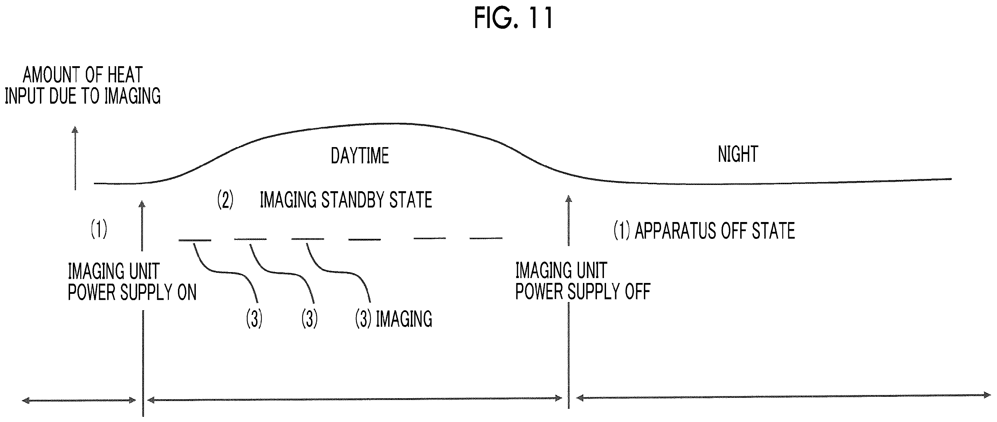

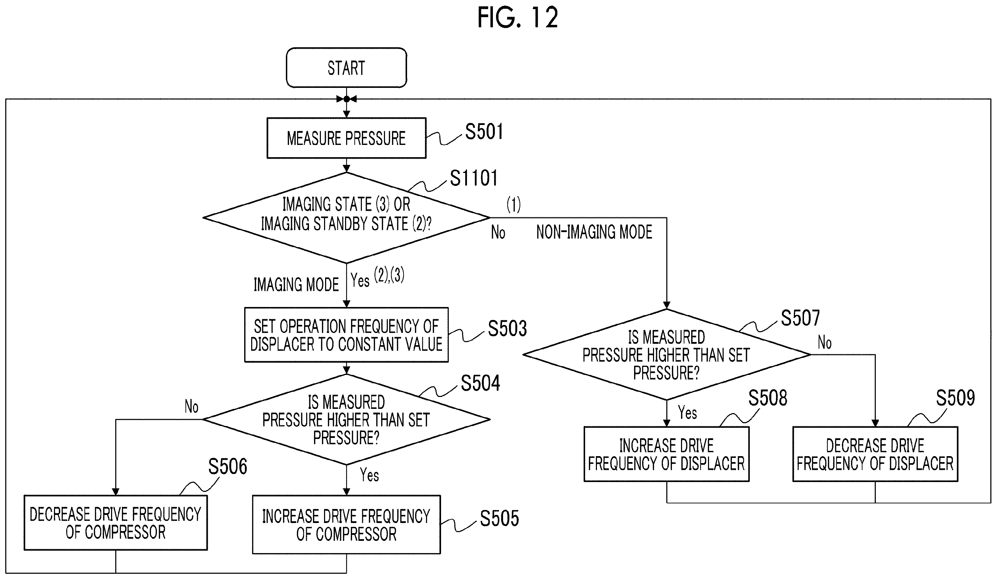

A fifth embodiment will be described with reference to FIGS. 11 and 12.

In the fifth embodiment, the imaging mode is executed in accordance with the state of the apparatus.

As illustrated in FIG. 11, in a hospital in which the imaging with the MRI apparatus 1 is performed only during daytime, the power supply of the imaging unit 10 of the MRI apparatus 1 is in an OFF state at night (state (1)), and only the minimum number of units, such as the cryocooler 70 of the superconducting magnet 101 and those for monitoring the apparatus state, remain energized.

In a case in which the hospital opens, the imaging unit 10 is powered on, which energizes all units such as the gradient magnetic field power supply 113 and RF transmission unit 116, and the imaging unit 10 enters an imaging standby state (state (2)). The subject 102 is positioned by the operator, the imaging protocol is set, and then the imaging is performed (state (3)).

As illustrated in the flow illustrated in FIG. 12, in the fifth embodiment, in step S1101, it is determined whether the imaging standby state (2) or the imaging state (3) is in progress, and in a case of the state (2) or (3), the imaging mode is executed by steps S503 to S506. As a result, the operation frequencies of the displacer 303a and 303b are set to a constant value, and the pressure in the inner vessel 201b of the superconducting magnet 101 is controlled to be constant by changing the drive frequency of the compressor drive unit 132 of the compressor 108.

In the state (1) at night, steps S507 to S509 are performed on the assumption that the imaging is not performed, and the frequencies of the displacers 303a and 303b are increased or decreased. In addition, although not illustrated in the flow illustrated in FIG. 12, it is possible to perform steps S703 and S705 illustrated in FIG. 9 or steps S802 and S804 illustrated in FIG. 10 in addition to steps S507 to S509, and to stop or restart the compressor 108 and the displacers 303a and 303b.

By performing the control as in the fifth embodiment, it is possible to ensure the energy saving effect to the maximum extent while suppressing the influence on the imaging to the minimum.

### Explanation of References

1: MRI apparatus
10: imaging unit
20: processor
21: imaging controller
22: image generation unit
25: display controller
30: UI unit
60: external storage device
70: cryocooler
101: superconducting magnet
102: subject
103: magnetic-field space
107: cold head
108: compressor
109: sensor connection terminal
110: magnet controller
111: shim plate
112: gradient coil
113: gradient magnetic field power supply
114: shim power supply
115: RF transmit coil
116: RF transmission unit
117: RF receive coil
118: RF reception unit
120: display
121: input device
122: table device
123: examination room
128: sequencer
131: mechanism unit
132: compressor drive unit
133: inverter for compressor
201: vacuum vessel
201a: outer vessel
201b: inner vessel
203: superconducting coil
204: liquid helium
205: liquid level sensor
206: temperature sensor
209: exhaust pipe
212: exhaust valve
213: pressure sensor
216: radiative heat shield plate
217: superinsulator
219: first cooling stage
220: second cooling stage
225: heat conduction member
301: GM cycle control unit
302: displacer drive unit
303: displacer
303a, 303b: displacer
304: cylinder
304a, 304b: cylinder
305: intake valve
306: exhaust valve
307: pressure gas hose
308: pressure gas hose
309: upper space
310: lower space

## Claims

1. A magnetic resonance imaging apparatus (1) comprising:
a superconducting magnet (101) that generates a static magnetic field in an imaging space,
wherein the superconducting magnet includes a superconducting coil (203), a vessel that houses the superconducting coil, liquid helium (204) that is disposed in the vessel, a cryocooler (70) that is attached to the vessel, a compressor (108) that supplies compressed refrigerant gas to the cryocooler, and a processor (20),
the compressor (108) includes a mechanism unit (131), a compressor drive unit (132) that periodically drives the mechanism unit to compress the refrigerant gas, and an inverter for a compressor that adjusts a drive frequency of the compressor drive unit,
the cryocooler includes a cylinder into which the refrigerant gas compressed by the compressor is supplied, a displacer (303) that is disposed in the cylinder, a displacer drive unit (302) that periodically drives the displacer in the cylinder, and an inverter for a cryocooler that adjusts a drive frequency of the displacer drive unit,
the processor controls the inverter for a compressor and the inverter for a cryocooler to control a pressure in the vessel, and
the processor has an imaging mode and a non-imaging mode and causes, in the imaging mode, the displacer to operate continuously at a constant frequency regardless of the pressure in the vessel.

2. The magnetic resonance imaging apparatus according to claim 1,
wherein the processor (20) sets the constant frequency at which the displacer is caused to operate in the imaging mode to a frequency that is lower than the drive frequency of the compressor drive unit.

3. The magnetic resonance imaging apparatus according to claim 1,
wherein in the non-imaging mode, the processor (20) causes the displacer to operate at a frequency that is lower than the constant frequency of the imaging mode.

4. The magnetic resonance imaging apparatus according to claim 3,
wherein in the non-imaging mode, the processor (20) stops the displacer in accordance with the pressure in the vessel.

5. The magnetic resonance imaging apparatus according to claim 1,
wherein the processor (20) determines the constant frequency at which the displacer is driven, based on a repetition frequency used as a parameter of an imaging sequence executed by the magnetic resonance imaging apparatus for imaging.

6. The magnetic resonance imaging apparatus according to claim 1,
wherein the processor (20) controls the drive frequency of the compressor drive unit in accordance with the pressure in the vessel, and stops the compressor and the displacer in a case in which the drive frequency of the compressor drive unit reaches a predetermined lower limit frequency.

7. The magnetic resonance imaging apparatus according to claim 1,
wherein the processor (20) controls the drive frequency of the compressor drive unit in accordance with the pressure in the vessel, and stops the compressor and the displacer in a case in which the pressure in the vessel reaches a predetermined lower limit pressure.

8. The magnetic resonance imaging apparatus according to claim 6,
wherein the processor (20) restarts the compressor and the displacer in a case in which a predetermined time elapses after the compressor and the displacer are stopped, in a case in which the pressure in the vessel reaches a predetermined upper limit pressure, or in a case in which the pressure in the vessel reaches a predetermined upper limit pressure.

9. The magnetic resonance imaging apparatus according to claim 1,
wherein the processor (20) executes the imaging mode in a case in which the magnetic resonance imaging apparatus is performing imaging or is in an imaging standby state.

10. A method of controlling a cryocooler (70) provided in a superconducting magnet of a magnetic resonance imaging apparatus (1),
wherein the cryocooler includes a cold head provided in the superconducting magnet and a compressor (108) that supplies compressed refrigerant gas to the cold head,
an imaging mode and a non-imaging mode are provided, and
in the imaging mode, a displacer of the cold head is caused to operate continuously at a constant frequency regardless of a pressure in a vessel of the superconducting magnet.
